# FASCICULE DE BREVET EUROPEEN

(11) **EP 2 398 230 B1**
(45) Date de publication et mention de la délivrance du brevet: **03.05.2017**
(21) Numéro de dépôt: 11354031.4
(22) Date de dépôt: 26.05.2011
(51) Int. Cl.: H04N 5/372, H04N 5/374, H04N 3/14, H01L 27/146

(54) **Capteur d'image linéaire en technologie CMOS**
Linearer Bildsensor mit CMOS-Technologie
Linear image sensor using CMOS technology

(30) Priorité: 03.06.2010 FR 1002360
(43) Date de publication de la demande: 21.12.2011
(73) Titulaire: Commissariat à l'Énergie Atomique et aux Énergies Alternatives, 75015 Paris (FR)
(72) Inventeur: Giffard, Benoit, 38000 Grenoble (FR); Cazaux, Yvon, 38100 Grenoble (FR)
(74) Mandataire: Talbot, Alexandre

(56) Documents cités:
- EP-A1- 2 154 879
- US-A1- 2004 159 861
- US-A1- 2008 210 993
- US-A1- 2008 211 940
- US-A1- 2009 295 971
- US-A1- 2010 118 167
- LEPAGE G ET AL: "Time-Delay-Integration Architectures in CMOS Image Sensors", IEEE TRANSACTIONS ON ELECTRON DEVICES, IEEE SERVICE CENTER, PISACATAWAY, NJ, US, vol. 56, no. 11, 1 novembre 2009 (2009-11-01), pages 2524-2533, XP011277605, ISSN: 0018-9383, DOI: 10.1109/TED.2009.2030648

## Description

### Domaine technique de l'invention

L'invention est relative à un capteur d'image linéaire destiné à saisir une image par balayage, notamment à un capteur à retard temporel et intégration, plus connu sous l'acronyme TDI (de l'anglais « Time Delay and Integration »).

### État de la technique

Les principes d'un capteur d'image TDI sont décrits, par exemple, dans l'article intitulé « A Large Area TDI Image Sensor for Low Light Level Imaging », par Michael G. Farrier et al - IEEE Journal of Solid-State Circuits, Vol. SC-15, No. 4, Août 1980.

Un capteur TDI est généralement utilisé pour saisir l'image d'un objet se déplaçant à vitesse élevée et observé sous de mauvaises conditions d'éclairage. Il est généralement réalisé en technologie CCD (de l'anglais « Charge-Coupled Device », ou dispositif à transfert de charges), qui a jusqu'à maintenant permis d'obtenir les meilleures performances en termes de sensibilité.

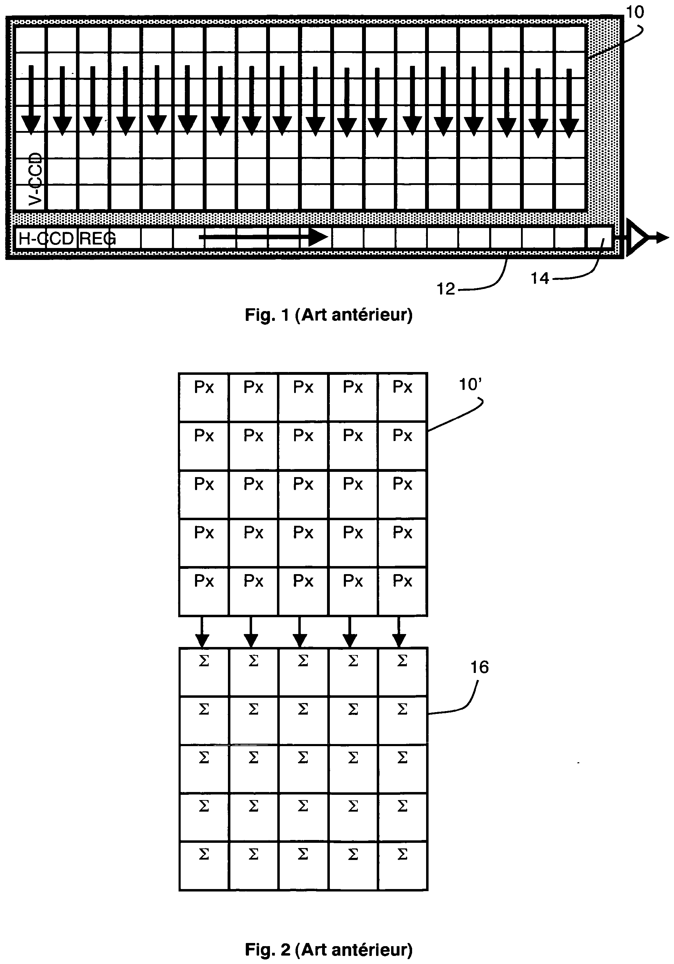

La figure 1 représente schématiquement un capteur TDI en technologie CCD, tel que décrit dans l'article susmentionné. Il comprend une matrice de sites photosensibles, ou photosites 10 dont les rangées sont généralement, comme cela est représenté, nettement plus longues que les colonnes. Dans l'exemple de l'article susmentionné, une rangée comporte 1028 photosites, tandis qu'une colonne en comporte seulement 128. Pour la photographie terrestre par satellite, une rangée peut comporter de l'ordre de 12000 photosites, et la matrice comporte quelques dizaines de rangées.

Les rangées de la matrice sont disposées perpendiculairement au déplacement de l'objet dont on veut saisir l'image. Le déplacement de cette image, relatif au capteur, est représenté par des flèches descendantes. Ces flèches correspondent également au déplacement des charges électriques dans les registres CCD, en synchronisme avec le déplacement de l'image.

Chaque rangée saisit une tranche correspondante de l'objet pendant un temps d'exposition compatible avec la vitesse de l'image. Cela provoque une accumulation de charges négatives (électrons) dans les photosites de la rangée.

Lorsqu'une tranche de l'image saisie par une rangée i s'est déplacée au niveau de la rangée i+1, les charges accumulées dans la rangée i sont transférées dans la rangée i+1, qui continue, pendant un nouveau temps d'exposition, à accumuler des charges pour la même tranche. Les transferts de charges d'une rangée à la suivante s'opèrent donc en synchronisme avec le déplacement de l'image.

La dernière rangée de la matrice contient ainsi, à chaque cycle de transfert, la somme des charges accumulées par toutes les rangées pour une même tranche. La sensibilité du capteur est donc, en théorie, multipliée par le nombre de rangées.

A la fin de chaque cycle de transfert de charges et d'exposition, les charges de la dernière rangée de la matrice sont transférées dans un registre à décalage 12 servant à la lecture des informations de la dernière rangée. Les charges stockées dans les photosites de ce registre sont décalées photosite par photosite vers un convertisseur charge-tension 14 en bout de rangée, où une tension correspondant à la charge totale de chaque photosite peut être prélevée par un circuit de traitement, généralement externe au capteur.

La technologie CCD étant de moins en moins utilisée pour les capteurs d'image, au profit de la technologie CMOS, l'utilisation de cette dernière technologie est envisagée pour les capteurs TDI.

L'article intitulé « Time-Delay-Integration Architectures in CMOS Image Sensors », par Gérald Lepage, Jan Bogaerts, et Guy Meynants - IEEE Transactions on Electron Devices, Vol. 56, NO. 11, novembre 2009, décrit des solutions pour obtenir la fonctionnalité TDI à l'aide d'un capteur d'image CMOS.

Dans un capteur d'image CMOS, la lumière est également captée sous forme de charges, au niveau de pixels. Par contre, chaque pixel étant muni de son propre circuit de lecture en tension, on ne peut pas transférer des charges d'un pixel à un autre.

La figure 2 représente schématiquement une architecture envisagée dans cet article de Lepage et al. À une matrice 10' de NxM pixels Px on associe une matrice 16 de cellules mémoire Σ de même taille et configuration (ici NxM = 5x5).

Dans le principe, la matrice de pixels 10' prend des vues à une cadence correspondant au temps (appelé « temps ligne » T_{L}) que met une tranche d'image à balayer le pas des rangées de pixels. Ainsi, au bout de N temps ligne, la même tranche d'image aura été saisie par chacune des N rangées de la matrice de pixels. Chaque rangée de la mémoire 16 est associée temporairement à une même tranche de l'image. On y accumule les niveaux de luminosité enregistrés pour cette tranche par toutes les rangées de pixels. Une fois que tous les niveaux ont été accumulés pour la tranche, la rangée mémoire est lue, réinitialisée, et associée de manière circulaire à une nouvelle tranche d'image.

On s'aperçoit qu'on doit ainsi procéder à l'accumulation de toutes les rangées de la matrice de pixels à chaque temps ligne.

Alors qu'en technologie CCD les opérations d'accumulation de niveaux de luminosité correspondent à de simples transferts de charges, en technologie CMOS ces opérations sont notablement plus complexes. Elles impliquent des multiplexages sur des bus de lecture des pixels, des conversions analogique-numérique, des opérations d'addition, et des opérations d'accès mémoire. Il en résulte qu'on a des difficultés en technologie CMOS à tenir les mêmes cadences de prise de vue (ou temps ligne T_{L}) qu'en technologie CCD. Ainsi, la résolution en nombre de rangées de la matrice de pixels doit être adaptée au temps ligne envisagé et au pas des pixels souhaité.

Dans certaines applications, on cherche à améliorer ce qu'on appelle la fonction de transfert de modulation (FTM) de filé qui est un des paramètres représentatifs de la netteté de l'image reproduite. Une FTM de filé faible se traduit généralement par une image floue. Cette perte de résolution est due au fait que, pendant un temps ligne, la tranche d'image se déplace au-dessus de la rangée de pixels, qui est fixe.

Comme cela est décrit dans l'article susmentionné de Lepage et al., une solution consiste à subdiviser chaque pixel en deux dans le sens du déplacement. Cela revient à augmenter le nombre de rangées de pixels tout en diminuant le pas pour conserver les dimensions du capteur. La FTM de filé passe de 0,64 à 0,9 lorsque le pixel est subdivisé en deux parts égales. En revanche, les contraintes temporelles, augmentant avec le carré du facteur de subdivision, sont multipliées par 4.

Le document US2004/0159861 décrit un capteur d'image ayant une structure de pixels partagés : quatre photodiodes partageant un même circuit de lecture. Chaque photodiode est séparée d'un noeud de stockage du circuit de lecture par un transistor de transfert. Les niveaux de luminosité de deux photodiodes sont transférés dans le noeud de stockage lors d'une première période, et les niveaux de luminosité des deux autres photodiodes sont transférés dans le noeud de stockage lors d'une seconde période.

Le document US2009/295971 décrit un quadruplet de pixels dont les charges sont sommées dans un même noeud de stockage. Pour se faire, les transistors de transfert entre chaque photodiode et le noeud de stockage sont commandés simultanément.

Le document US2010/118167 divulgue un pixel à quatre photodiodes qui partagent un même noeud de stockage. Un transistor de transfert sépare chaque photodiode du noeud de stockage. En outre, un transistor supplémentaire sépare le noeud de stockage du pixel du noeud de stockage du pixel adjacent. Ce transistor supplémentaire permet de répartir, entre deux noeuds de stockage, les niveaux de luminosité de deux photodiodes appartenant à deux pixels distincts, pour réaliser une moyenne de leurs niveaux de luminosité ou adapter le gain du pixel.

### Résumé de l'invention

On constate qu'il existe un besoin de prévoir un capteur d'image de type TDI réalisé en technologie CMOS permettant d'améliorer la FTM de filé sans toutefois augmenter les contraintes temporelles.

On tend à satisfaire ce besoin en prévoyant un capteur d'image selon la revendication 1. On prévoit également un procédé de gestion d'un capteur d'image à retard temporel et intégration selon la revendication 6.

### Description sommaire des dessins

D'autres avantages et caractéristiques ressortiront plus clairement de la description qui va suivre de modes particuliers de réalisation donnés à titre d'exemples non limitatifs et illustrés à l'aide des dessins annexés, dans lesquels :
- la figure 1, précédemment décrite, représente schématiquement un capteur d'image TDI classique, réalisé en technologie CCD ;
- la figure 2, précédemment décrite, représente schématiquement un capteur TDI classique réalisé en technologie CMOS ;
- la figure 3 représente un pixel de capteur CMOS à quatre transistors ;
- la figure 4 représente schématiquement une colonne d'un capteur TDI en technologie CMOS permettant d'améliorer la FTM de filé ;
- les figures 5 à 8 représentent des étapes de fonctionnement des pixels de la figure 4 ; et
- les figures 9A à 9H sont des chronogrammes illustrant un fonctionnement global des pixels du capteur de la figure 4.

### Description d'un mode de réalisation préféré de l'invention

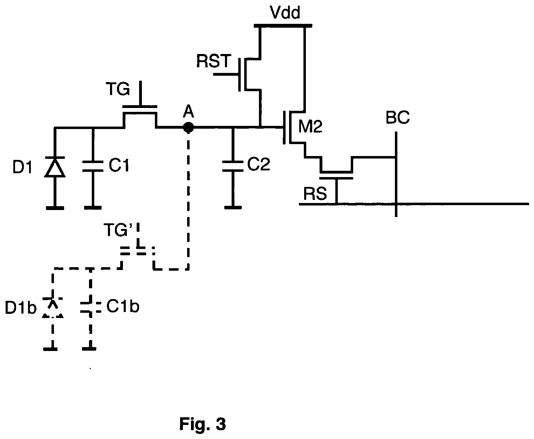

La figure 3 représente en trait plein un pixel CMOS de type classique dit « 4T ». Ce type de pixel sera adapté par la suite afin de réduire l'effet de filé dans un capteur TDI. Il comprend une photodiode D1, dont la capacité intrinsèque C1, ou capacité d'intégration, permet d'accumuler les charges générées par la lumière frappant le pixel. Un transistor de transfert TG relie la photodiode D1 à la grille d'un transistor suiveur M2. La capacité de grille du transistor M2 ainsi que les capacités des autres éléments reliés à un même noeud A forment une capacité tampon C2. Un transistor de sélection RS relie la source du transistor suiveur M2 à un bus de colonne BC. Un transistor de réinitialisation RST relie la capacité C2 à une ligne d'alimentation positive Vdd. Pour des raisons de commodité, les signaux de commande des transistors ont ci-après le même nom que les transistors.

Le fonctionnement de ce pixel est en bref le suivant. La capacité C1 intègre les charges engendrées par la lumière frappant la photodiode D1. Avant la fin de l'exposition, le transistor RST est actionné brièvement pour réinitialiser la capacité tampon C2. En fin d'exposition, le transistor TG est actionné brièvement pour transférer les charges de la capacité C1 vers la capacité tampon C2. Si la photodiode D1 est de type verrouillé (« pinned » en anglais), le transfert de charges est total, d'où il résulte aussi que la capacité C1 est réinitialisée par l'actionnement du transistor TG.

Ainsi, pendant chaque phase d'exposition, le niveau de tension correspondant à l'exposition précédente est stocké sur la capacité tampon C2. Ce niveau de tension, représentatif d'un niveau de luminosité, peut être transféré à tout moment sur le bus BC en actionnant le transistor de sélection RS, ceci avant la réinitialisation par le transistor RST.

Dans une matrice de pixels selon la figure 3, les pixels d'une colonne partagent le même bus BC. Les pixels d'une colonne sont lus rangée après rangée et leurs signaux transitent vers une matrice de cellules mémoire Σ par l'intermédiaire du bus de colonne BC pour y être stockés (Fig.2). Une rangée est sélectionnée par l'intermédiaire du signal RS.

La capacité C2, de valeur relativement faible pour minimiser le bruit de lecture, présente à sa réinitialisation un niveau de « noir » bruité, qui vient s'ajouter au niveau utile transféré depuis la capacité C1. Pour atténuer l'effet de ce bruit, on procède généralement à un double échantillonnage corrélé, c'est-à-dire qu'on échantillonne d'abord les niveaux de noir des pixels, pour les retrancher ensuite aux niveaux utiles échantillonnés après transfert depuis la capacité C1. Cette différence est généralement réalisée dans une mémoire externe (non représentée).

Un autre type de pixel, dit « pixel partagé », tel que décrit dans la demande de brevet US2006-0256221, peut être dérivé de celui de la figure 3 en ajoutant les éléments en pointillés, à savoir une deuxième photodiode D1b reliée au noeud A par un deuxième transistor de transfert TG'. Le but de cette structure est de réduire l'encombrement des pixels en partageant un circuit de lecture entre plusieurs photodiodes. Le niveau de chaque photodiode est transféré séparément vers le bus BC selon une phase telle que décrite ci-dessus. Ainsi, la capacité C2 est réinitialisée au début de chacune de ces deux phases et ne peut servir, comme dans un pixel 4T simple, à stocker les informations d'une image précédente pendant l'acquisition d'une image courante.

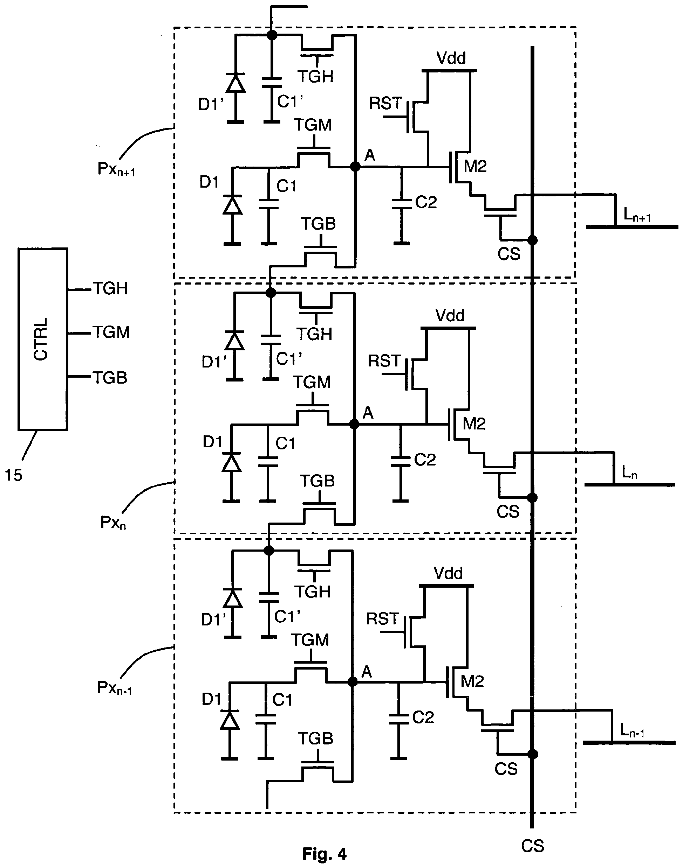

La figure 4 représente une colonne de pixels Px modifiés dans le but d'améliorer la FTM de filé.

Afin d'améliorer la FTM de filé, on prévoit deux photodiodes dans chaque pixel. L'intégration des charges associées à une tranche d'image n'a plus lieu pendant un temps ligne dans une seule photodiode, mais pendant deux moitiés de temps ligne dans deux photodiodes distinctes. Cela permet, en organisant convenablement les transferts de charge de ces photodiodes, de synchroniser plus fidèlement l'intégration des charges avec le défilement de l'image, limitant ainsi l'effet de filé (ou « de bougé ») à une moitié de temps ligne (ou à un demi-pas de pixel).

Chaque pixel Px ressemble structurellement à un pixel partagé. Il comprend deux éléments photosensibles D1 et D1' alignés dans le sens de la colonne. De préférence, les photodiodes sont de type verrouillé et de mêmes dimensions. La photodiode D1 munie de la capacité d'intégration C1 est connectée au noeud de stockage A (la capacité de stockage C2) par l'intermédiaire d'un élément de transfert TGM, par exemple un transistor MOS. De façon similaire, la deuxième photodiode D1' et sa capacité d'intégration C1' sont connectées au noeud A par l'intermédiaire d'un deuxième transistor de transfert TGH.

Contrairement à une colonne qui serait composée de pixels partagés classiques, chaque pixel comprend un troisième transistor de transfert TGB reliant la capacité de stockage C2 à la photodiode D1' d'un pixel adjacent de la colonne. Sur la figure 4, la capacité C2 du pixel Px de rangée *n*+*1* (Pxₙ₊₁) est reliée à la photodiode D1' du pixel de rangée n (Pxₙ), la capacité C2 du pixel de rangée n est reliée à la photodiode D1' du pixel de rangée *n-1*, etc.

Comme dans le circuit de la figure 3, chaque pixel dispose d'un transistor suiveur M2, d'un transistor RST relié à une tension d'alimentation Vdd afin de réinitialiser la capacité C2, et d'un transistor de sélection, ici noté CS, permettant le transfert d'un niveau de luminosité vers un bus de lecture L. Ce signal est acheminé vers un convertisseur analogique-numérique (non représenté) situé à une extrémité du bus de lecture L.

Dans cette configuration, le bus de lecture L est commun à tous les pixels de la rangée et il n'y a qu'un convertisseur analogique-numérique par rangée. De plus, les grilles des transistors CS de la colonne sont reliées à une même ligne de commande, également notée CS. Cette ligne de commande CS permet de sélectionner toute une colonne de pixels pour la lecture.

Les transistors TGH, TGM et TGB de chaque pixel Pₓ de la figure 4 sont commandés par un circuit de commande 15.

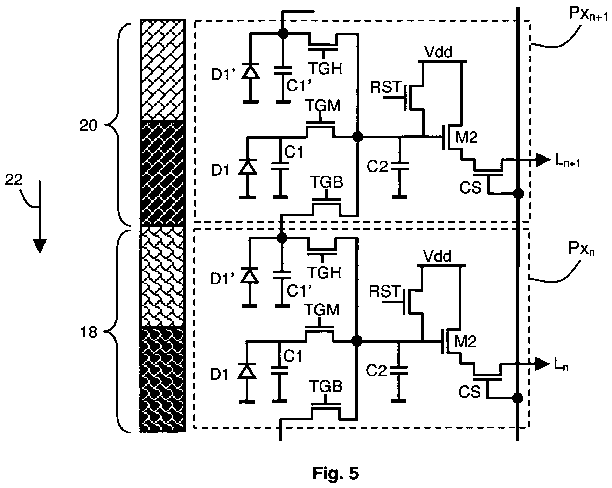

Les figures 5 à 8 illustrent des étapes de fonctionnement d'une colonne de pixels selon la figure 4. Des tranches d'image successives 18, 20 défilent le long de la colonne de pixels dans le sens de la flèche 22 indiquée sur la figure 5. Chaque tranche d'image est divisée en deux moitiés pour mieux illustrer le synchronisme entre le défilement de la tranche et les phases de fonctionnement du capteur. Le fonctionnement est décrit ci-après en relation avec deux pixels consécutifs Pxₙ₊₁ et Pxₙ quelconques.

La figure 5 représente schématiquement une position de l'image par rapport aux pixels au cours d'une première période d'intégration T₁ correspondant au temps de défilement d'une demi-tranche d'image devant une photodiode. Les photodiodes D1 et D1' du pixel Pxₙ sont exposées à une tranche d'image 18 et les photodiodes D1 et D1' du pixel Pxₙ₊₁ sont exposées à une tranche d'image 20. Pendant cette période T₁, les capacités d'intégration C1 et C1' de chaque pixel accumulent les charges correspondant à chaque tranche. Tous les transistors sont bloqués.

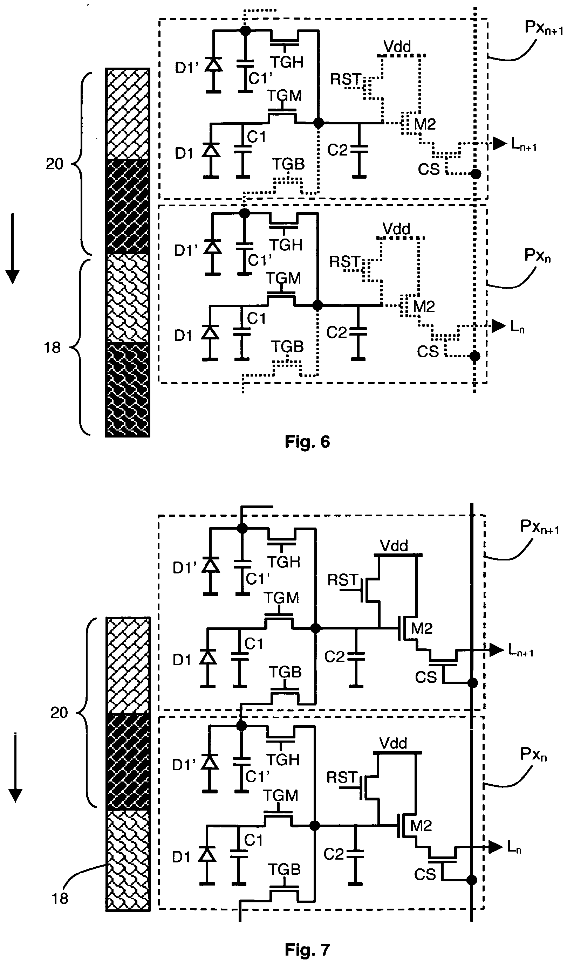

Sur la figure 6, à la fin de la période d'intégration T₁, les transistors TGH et TGM sont rendus passants et transfèrent vers la capacité C2 du pixel les charges stockées dans les capacités C1 et C1' du pixel. La capacité C2 du pixel Pxₙ₊₁ reçoit les charges correspondant aux deux moitiés de la tranche 20 et la capacité C2 du pixel Pxₙ reçoit les charges correspondant aux deux moitiés de la tranche 18. Les autres éléments du pixel, représentés en traits pointillés, sont désactivés. Les tranches d'image 18 et 20 se sont déplacées approximativement d'une moitié de pas de pixel pendant la période T₁.

La figure 7 représente schématiquement une position de l'image au cours d'une seconde période d'intégration T₂. La tranche d'image 20 est à cheval entre les deux pixels adjacents. La partie inférieure de la tranche 20 est captée par la photodiode D1' du pixel Pxₙ tandis que la partie supérieure de la tranche 20 est captée par la photodiode D1 du pixel Pxₙ₊₁. Cette période correspond donc au passage d'une tranche d'image d'un pixel à un autre. Tous les transistors sont bloqués. Au cours de la période T₂, les tranches d'image 18 et 20 se déplaceront également d'une moitié de pas, marquant ainsi la fin d'un temps ligne.

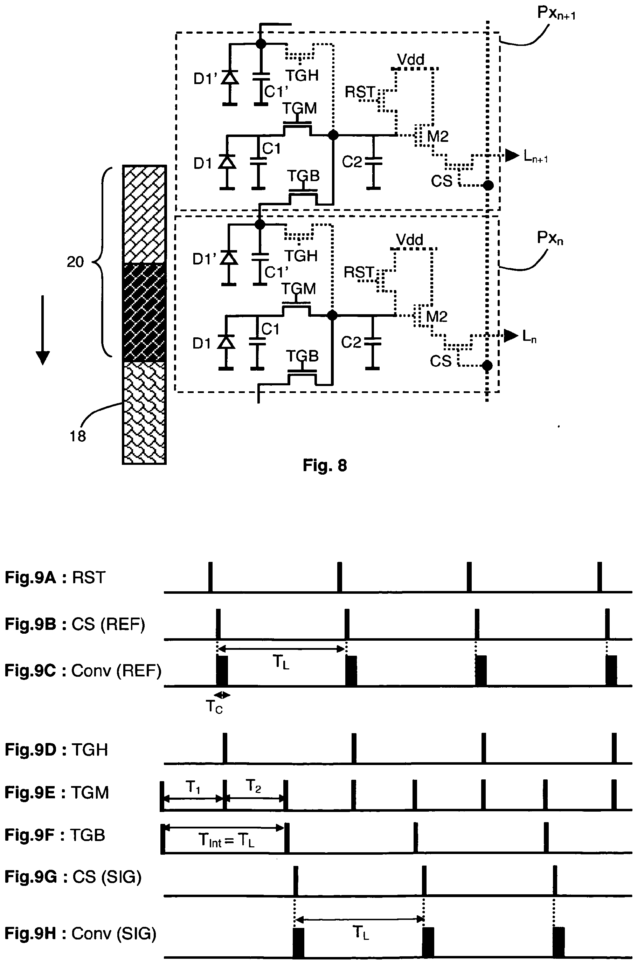

Sur la figure 8, à la fin de la période d'intégration T₂, les transistors TGB et TGM sont actionnés. Dans cette configuration, les charges correspondant aux deux moitiés de la tranche 20 intégrées pendant la période T₂ sont de nouveau transférées à la capacité C2 du pixel Pxₙ₊₁, où elles s'accumulent avec les charges précédemment stockées dans la capacité C2 pour la même tranche lors de l'étape de la figure 6.

Après avoir activé les transistors TGB et TGM, la capacité C2 du pixel Pxₙ₊₁ regroupe les niveaux de luminosité pour deux positions consécutives de la tranche 20 et la capacité C2 du pixel Pxₙ regroupe les niveaux de luminosité pour deux positions consécutives de la tranche 18. Ces niveaux de luminosité accumulés peuvent être extraits des pixels à l'aide des transistors M2 et CS à la fin de la période T2. En d'autres termes, chaque pixel contient une information de résolution double qu'il suffit de lire à fréquence simple. Cela permet d'améliorer la FTM de filé sans augmenter les contraintes temporelles pour lire les informations.

Les figures 9A à 9H sont des chronogrammes résumant le fonctionnement global d'une colonne de pixels selon la figure 4. Les figures 9A, 9B, 9D à 9G représentent les signaux de commande (ou les états) des transistors RST, CS, TGH, TGM, TGB. Les signaux 9C et 9H représentent l'activité du convertisseur analogique-numérique qui traite les données après lecture via le bus L.

Un double échantillonnage corrélé est employé afin de s'affranchir du bruit de réinitialisation. L'activation du transistor de sélection CS pour une lecture du niveau de noir REF est représentée séparément de l'activation pour une lecture du niveau de luminosité (accumulé) SIG (Fig.9B, 9G). De même, la conversion du niveau REF est représentée séparément de celle du niveau SIG (Fig.9C,9H).

Une durée d'exposition Tᵢₙₜ d'une tranche, correspondant généralement au temps ligne T_{L}, est définie entre deux activations successives du transistor de transfert TGH ou TGB. Pendant cette durée ont lieu les périodes d'intégration T₁ et T₂ (T₁=T₂=Tᵢₙₜ/2). La périodicité des signaux reflète le traitement des tranches consécutives de l'image.

La tranche d'image est tout d'abord balayée par les photodiodes D1 et D1' d'un même pixel pendant la période T₁, comme décrit en relation avec la figure 5. Avant de transférer les charges ainsi obtenues dans la capacité C2, celle-ci est remise à zéro en actionnant le transistor RST (Fig.9A). Peu après la réinitialisation de la capacité C2, le transistor CS est activé (Fig.9B) afin de lire puis convertir le niveau de noir REF (Fig.9C). Le temps de conversion T_{c} ayant une durée supérieure à la durée d'une impulsion du signal CS, il est représenté par un trait plus épais sur la figure 9C.

Une fois le niveau de noir transféré au convertisseur, les transistors TGH et TGM sont actionnés pour stocker les premiers niveaux de luminosité (Fig.9D, Fig.9E), ce qui marque la fin de la période T₁ et le début de la période T₂.

Lors de la période T₂, la tranche d'image est balayée par la photodiode D1 du même pixel et la photodiode D1' du pixel suivant. Le transfert des niveaux de luminosité associés est effectué à la fin de la période T₂ par l'activation des transistors TGM et TGB (Fig.9E, Fig.9F).

Une fois ce transfert des charges accompli, les niveaux de luminosité cumulés SIG sont lus en activant de nouveau le transistor CS (Fig.9G), puis échantillonnés par le convertisseur analogique-numérique (Fig.9H), avant d'être stockés dans la matrice de cellules mémoire Σ. Une nouvelle exposition démarre alors avec la tranche suivante.

On remarque que le transistor de transfert central TGM est sollicité deux fois plus souvent que les transistors TGB et TGH. En effet, la photodiode D1 connectée au transistor TGM balaye la tranche entière (soit deux demi-tranches) tandis que les photodiodes D1' (celle appartenant au pixel et celle appartenant au pixel adjacent) balayent seulement une moitié de tranche.

Sur les figures 9D à 9F, les transistors TGH et TGM, ou les transistors TGB et TGM, sont commandés simultanément. On pourrait également les actionner l'un après l'autre.

Pendant un temps ligne, la matrice de pixels doit être lue en totalité et sommée dans la matrice mémoire 16. Cette lecture s'effectue colonne après colonne (mode « rolling shutter »), en lisant les pixels de chaque colonne simultanément. Le convertisseur d'une ligne réalise donc autant de conversions qu'il y a de colonnes dans la matrice de pixels pendant un temps ligne T_{L}. Les chronogrammes d'une colonne adjacente à celle de la figure 4 sont simplement décalés d'un temps de conversion T_{c}.

La matrice mémoire 16, étant gérée de la même manière que dans le cas d'un capteur TDI-MOS classique, ne sera pas détaillée dans la présente demande.

Ainsi, chaque tranche d'image est balayée deux fois pour un déplacement d'un pas de pixel : une première fois par la photodiode D1 et une seconde fois par la photodiode D1' qui est décalée d'un demi-pas de pixel par rapport à la photodiode D1. Ce sur-échantilonnage particulier permet d'améliorer de façon significative la FTM de filé, qui passe de 0,637 à 0,9 environ (calculée à la fréquence de Nyquist). Contrairement aux techniques de l'art antérieur, le pas d'un pixel n'est pas modifié, de même que la résolution spatiale de l'image. Les contraintes temporelles sont donc inchangées.

En fait, les contraintes temporelles sont imposées par le circuit de lecture et le convertisseur analogique-numérique. En effet, pour une matrice de m colonnes, m conversions (ou 2m conversions en cas de double échantillonnage) doivent être réalisées dans un temps ligne T_{L}. Le temps ligne étant prédéterminé en fonction de la vitesse de balayage de l'image et du pas, c'est la rapidité du circuit de lecture et de conversion qui limite le nombre de colonnes de la matrice.

## Revendications

1. Capteur d'image à retard temporel et intégration comprenant une matrice (10') de pixels (Px) organisés en rangées et colonnes, chaque pixel comprenant :
- un premier élément photosensible (D1),
- un noeud de stockage (A, C2),
- un premier élément de transfert (TGM) connecté entre le premier élément photosensible (D1) et le noeud de stockage (A),
- un second élément photosensible (D1'),
- un deuxième élément de transfert (TGH) connecté entre le second élément photosensible (D1') et le noeud de stockage (A),
- un troisième élément de transfert (TGB) connecté entre le noeud de stockage (A) et le second élément photosensible (D1') d'un pixel adjacent de la colonne,
**caractérisé en ce que** le capteur d'image comporte un circuit\de commande (15) agencé pour commander simultanément les premier et deuxième éléments de transfert (TGM, TGH) à l'état passant et le troisième élément de transfert (TGB) à l'état bloqué, et pour, dans une phase distincte, commander simultanément les premier et troisième éléments de transfert (TGM, TGB) à l'état passant et le deuxième élément de transfert (TGH) à l'état bloqué.

2. Capteur d'image selon la revendication 1, **caractérisé en ce qu'**il comprend :
- pour chaque rangée de pixels (Px), un bus de lecture (L) commun aux pixels de la rangée, et
- pour chaque colonne de pixels, une ligne de sélection en lecture (CS) commune aux pixels de la colonne.

3. Capteur d'image selon la revendication 2, **caractérisé en ce qu'**il comprend une matrice (16) de cellules mémoire (Σ) connectée aux bus de lecture (L) pour stocker dans une rangée de cellules mémoire des niveaux de luminosité accumulés de plusieurs rangées de pixels (Px).

4. Capteur d'image selon la revendication 1, **caractérisé en ce qu'**il comprend des moyens (RST) pour opérer un double échantillonnage corrélé de chaque pixel (Px).

5. Capteur d'image selon la revendication 1, **caractérisé en ce que** les premier et second éléments photosensibles (D1, D1') sont des diodes verrouillées de mêmes dimensions.

6. Procédé de gestion d'un capteur d'image à retard temporel et intégration muni d'une matrice (10') de pixels (Px) organisés en rangées et colonnes comprenant, pour chaque pixel d'une colonne, les étapes successives :
o exposer des premier et second éléments photosensibles (D1, D1') du pixel à une première tranche d'image (18) pendant une première demi période (T₁) ;
o transférer simultanément le niveau de luminosité du premier élément photosensible (D1) seulement dans un noeud de stockage (A) du pixel et transférer le niveau de luminosité du second élément photosensible (D1') seulement dans noeud de stockage (A) du pixel ;
o exposer le premier élément photosensible (D1) du pixel à la première tranche d'image (18) et le second élément photosensible (D1') du pixel à une deuxième tranche d'image (20) pendant une seconde demi période (T₂), les première et deuxième tranches d'image s'étant déplacées d'un demi pas de pixel le long de la colonne pendant les première et seconde demi périodes ;
o transférer simultanément le niveau de luminosité du premier élément photosensible (D1) seulement dans le noeud de stockage (A) du pixel et transférer le niveau de luminosité du second élément photosensible (D1') seulement dans le noeud de stockage (A) d'un pixel adjacent de la colonne : et
o lire les niveaux de luminosité accumulés dans le noeud de stockage (A) du pixel.

7. Procédé selon la revendication 6, comprenant les étapes suivantes :
o lire le niveau de noir (REF) du pixel (Px) avant chaque lecture des niveaux de luminosité accumulés (SIG) du pixel ; et
o soustraire le niveau de noir aux niveaux de luminosité accumulés.

8. Procédé selon la revendication 6, **caractérisé en ce que** les pixels (Px) d'une même colonne sont commandés simultanément et les colonnes sont adressées successivement pendant une même période.

## Patentansprüche

1. Bildsensor mit zeitlicher Verzögerung und Integration, der eine Matrix (10') aus Pixeln (Px), welche in Reihen und Spalten angeordnet sind, umfasst, wobei jedes Pixel umfasst:
- ein erstes lichtempfindliches Element (D1),
- einen Speicherknoten (A, C2),
- ein erstes Übertragungselement (TGM), das zwischen dem ersten lichtempfindlichen Element (D1) und dem Speicherknoten (A) angeschlossen ist,
- ein zweites lichtempfindliches Element (D1'),
- ein zweites Übertragungselement (TGH), das zwischen dem zweiten lichtempfindlichen Element (D1') und dem Speicherknoten (A) angeschlossen ist,
- ein drittes Übertragungselement (TGB), das zwischen dem Speicherknoten (A) und dem zweiten lichtempfindlichen Element (D1') eines benachbarten Pixels der Spalte angeschlossen ist,
**dadurch gekennzeichnet, dass** der Bildsensor einen Steuerkreis (15) umfasst, der dazu eingerichtet ist, das erste und das zweite Übertragungselement (TGM, TGH) im Durchlasszustand und das dritte Übertragungselement (TGB) im Sperrzustand gleichzeitig zu steuern, und in einer separaten Phase das erste und das dritte Übertragungselement (TGM, TGB) im Durchlasszustand und das zweite Übertragungselement (TGH) im Sperrzustand gleichzeitig zu steuern.

2. Bildsensor nach Anspruch 1, **dadurch gekennzeichnet, dass** er umfasst:
- für eine jede Reihe von Pixeln (Px) einen Lesebus (L), der den Pixeln der Reihe gemein ist, und
- für eine jede Spalte von Pixeln eine Leseauswahlleitung (CS), die den Pixeln der Spalte gemein ist.

3. Bildsensor nach Anspruch 2, **dadurch gekennzeichnet, dass** er eine Matrix (16) aus Speicherzellen (Σ) umfasst, die an den Lesebus (L) angeschlossen ist, um in einer Reihe von Speicherzellen kumulierte Helligkeitspegel von mehreren Reihen von Pixeln (Px) zu speichern.

4. Bildsensor nach Anspruch 1, **dadurch gekennzeichnet, dass** er Mittel (RST) zum Durchführen einer korrelierten Doppelabtastung eines jeden Pixels (Px) umfasst.

5. Bildsensor nach Anspruch 1, **dadurch gekennzeichnet, dass** das erste und das zweite lichtempfindliche Element (D1, D1') gepinnte Dioden mit gleichen Abmessungen sind.

6. Verfahren zum Steuern eines Bildsensors mit zeitlicher Verzögerung und Integration, der mit einer Matrix (10') aus Pixeln (Px), welche in Reihen und Spalten angeordnet sind, ausgestattet ist, umfassend die aufeinanderfolgenden Schritte für jedes Pixel einer Spalte:
- Aussetzen von ersten und zweiten lichtempfindlichen Elementen (D1, D1') des Pixels einem ersten Bildabschnitt (18) während einer ersten halben Periode (T₁);
- gleichzeitiges Übertragen des Helligkeitspegels des ersten lichtempfindlichen Elements (D1) nur in einen Speicherknoten (A) des Pixels und Übertragen des Helligkeitspegels des zweiten lichtempfindlichen Elements (D1') nur in den Speicherknoten (A) des Pixels;
- Aussetzen des ersten lichtempfindlichen Elements (D1) des Pixels dem ersten Bildabschnitt (18) und des zweiten lichtempfindlichen Elements (D1') des Pixels einem zweiten Bildabschnitt (20) während einer zweiten halben Periode (T₂), wobei sich der erste und der zweite Bildabschnitt während der ersten und der zweiten halben Periode um einen halben Pixelabstand entlang der Spalte bewegt haben;
- gleichzeitiges Übertragen des Helligkeitspegels des ersten lichtempfindlichen Elements (D1) nur in den Speicherknoten (A) des Pixels und Übertragen des Helligkeitspegels des zweiten lichtempfindlichen Elements (D1') nur in den Speicherknoten (A) eines benachbarten Pixels der Spalte; und
- Auslesen der in dem Speicherknoten (A) des Pixels kumulierten Helligkeitspegel.

7. Verfahren nach Anspruch 6, das die folgenden Schritte umfasst:
- Auslesen des Schwarzniveaus (REF) des Pixels (Px) vor jedem Auslesen der kumulierten Helligkeitspegel (SIG) des Pixels; und
- Subtrahieren des Schwarzniveaus von den kumulierten Helligkeitspegeln.

8. Verfahren nach Anspruch 6, **dadurch gekennzeichnet, dass** die Pixel (Px) einer gleichen Spalte gleichzeitig gesteuert werden und die Spalten während einer gleichen Periode nacheinander angesprochen werden.

## Claims

1. A time-delay-integration image sensor comprising a matrix (10') of pixels (Px) organized in rows and columns, each pixel comprising:
- a first photosensitive element (D1),
- a storage node (A, C2),
- a first transfer element (TGM) connected between the first photosensitive element (D1) and the storage node (A),
- a second photosensitive element (D1'),
- a second transfer element (TGH) connected between the second photosensitive element (D1') and the storage node (A),
- a third transfer element (TGB) connected between the storage node (A) and the second photosensitive element (D1') of an adjacent pixel of the column,
and **characterized in that** the image sensor comprises a control circuit (15) configured to simultaneously command the first and second transfer elements (TGM, TGH) to on state and the third transfer element (TGB) to off state, and in a distinct phase, to simultaneously command the first and third transfer elements (TGM, TGB) to on state and the second transfer element (TGH) to off state.

2. The image sensor according to claim 1, **characterized in that** it comprises:
- for each row of pixels (Px), a read bus (L) common to the pixels of the row, and
- for each column of pixels, a read selection line (CS) common to the pixels of the column.

3. The image sensor according to claim 2, **characterized in that** it comprises a matrix (16) of memory cells (Σ) connected to the read busses (L) to store accumulated brightness levels of several rows of pixels (Px) in a row of memory cells.

4. The image sensor according to claim 1, **characterized in that** it comprises means (RST) for performing correlated double sampling of each pixel (Px).

5. The image sensor according to claim 1, **characterized in that** the first and second photosensitive elements (D1, D1') are pinned diodes of the same dimensions.

6. A method for management of a time-delay-integration image sensor comprising a matrix (10') of pixels (Px) organized in rows and columns, comprising, for each pixel of a column, the successive steps of:
o exposing first and second photosensitive elements (D1, D1') of the pixel to a first image slice (18) during a first half period (T₁);
o simultaneously transferring the brightness level of the first photosensitive element (D1) only to a storage node (A) of the pixel and transferring the brightness level of the second photosensitive element (D1') only to the storage node (A) of the pixel;
o exposing the first photosensitive element (D1) of the pixel to a first image slice (18) and the second photosensitive element of the pixel (D1') to a second image slice (20) during a second half period (T₂), the first and second image slices having moved along the column a half of a pixel pitch during the fist and second half periods;
o simultaneously transferring the brightness level of the first photosensitive element (D1) only to the storage node (A) of the pixel and transferring the brightness level of the second photosensitive element (D1') only to the storage node (A) of an adjacent pixel of the column; and
o reading the accumulated brightness levels in the storage node (A) of the pixel.

7. The method according to claim 6, comprising the following steps:
o reading the black level (REF) of the pixel (Px) before each read of the accumulated brightness levels (SIG) of the pixel; and
o subtracting the black level from the accumulated brightness levels.

8. The method according to claim 6, **characterized in that** the pixels (Px) of one and the same column are commanded simultaneously and the columns are addressed successively during one and the same period.
